# Europäisches Patentamt
## European Patent Office
### Office européen des brevets

(11) Veröffentlichungsnummer: **0 216 135**
**B1**

(12) **EUROPÄISCHE PATENTSCHRIFT**

(45) Veröffentlichungstag der Patentschrift: **09.05.90**

(51) Int. Cl.⁵: **G 01 R 31/28,** G 01 R 31/02, G 01 R 1/073

(21) Anmeldenummer: **86111442.9**

(22) Anmeldetag: **19.08.86**

(54) Vorrichtung für die elektrische Funktionsprüfung von Verdrahtungsfeldern, insbesondere von Leiterplatten.

(30) Priorität: **04.09.85 DE 3531594**

(43) Veröffentlichungstag der Anmeldung: **01.04.87 Patentblatt 87/14**

(45) Bekanntmachung des Hinweises auf die Patenterteilung: **09.05.90 Patentblatt 90/19**

(84) Benannte Vertragsstaaten: **AT BE CH DE FR GB IT LI NL SE**

(56) Entgegenhaltungen:
EP-A-0 102 565
EP-A-0 107 771

IBM TECHNICAL DISCLOSURE BULLETIN, Band 14, Nr. 5, Oktober 1971, Seite 1601, New York, US; H. BOHLEN et al.: "Tester for electric conductors"

(73) Patentinhaber: **Siemens Aktiengesellschaft Wittelsbacherplatz 2 D-8000 München 2 (DE)**

(72) Erfinder: **Doemens, Günter, Dr. Föchingerstrasse 4 D-8150 Holzkirchen (DE)**

Courier Press, Leamington Spa, England.

EP 0 216 135 B1

**Beschreibung**

Die Erfindung betrifft eine Vorrichtung für die elektrische Funktionsprüfung von Verdrahtungsfeldern, insbesondere von Leiterplatten, nach dem Oberbegriff des Anspruchs 1.

In Prüfautomaten und Prüfadaptern für unbestückte und bestückte Leiterplatten sowie für Verdrahtungsfelder in Löt- oder Crimptechnik wird die Kontaktierung der ausgewählten Meßstellen in der Regel über federnde Prüfspitzen vorgenommen. Die entsprechend dem Rastermaß eines zu prüfenden Verdrahtungsfeldes angeordneten federnden Prüfspitzen werden mittels Federhülsen befestigt, die in eine Trägerplatte eingepreßt sind und in die man die Prüfspitzen einschiebt. Bei der Auswahl der Prüfspitzen entscheiden üblicherweise der kleinste Abstand der Meßstellen zueinander sowie die Strombelastung über den Durchmesser der federnden Prüfspitzen, wobei als unteres Grenzmaß für den Durchmesser jedoch 0,69 mm genannt werden (Elektronik Produktion & Prüftechnik, November 1979, Seiten 472 und 473).

Mit den bekannten Vorrichtungen für die elektrische Funktionsprüfung von Leiterplatten werden zwischen den durch Rasterpunkte entsprechend dem Layout gebildeten Prüfstellen Leitfähigkeits- und Isolationsmessungen durchgeführt. Da die für die Ankontaktierung der Prüfstellen vorgesehenen federnden Prüfspitzen im Raster der Leiterplatte angeordnet werden müssen, stößt die Realisierung derartiger Vorrichtungen bei abnehmendem Rastermaß und größer werdenden Flächen der Leiterplatten zunehmend auf prinzipielle Schwierigkeiten. So ist eine Anordnung der federnden Prüfspitzen in Rastermaßen unter einem Millimeter bei einer sicheren mechanischen Kontaktierung der Prüfstellen feinwerktechnisch kaum mehr beherrschbar. Mit der Anzahl der Meßstellen, die beispielsweise Hunderttausend betragen kann, steigt auch die Anzahl der erforderlichen Zuleitungen und Schaltelemente, wodurch ein erheblicher gerätetechnischer Aufwand und entsprechend hohe Kosten verursacht werden. Außerdem nimmt mit der Anzahl der Meßstellen auch die Wahrscheinlichkeit einer vollständigen Kontaktierung der Leiterplatten erheblich ab.

Der nächstliegende Stand der Technik entsprechend dem Oberbegriff des Anspruches 1, ist aus der EP—A—0 102 565 bekannt, in der eine Vorrichtung für die elektrische Funktionsprüfung von Verdrahtungsfeldern beschrieben wird, bei welcher die bisher übliche ohm'sche Kontaktierung der Meßstellen durch eine berührungslose ionische Kontaktierung über Gasentladungsstrecken ersetzt wird. Hierzu wird in eine auf die Verdrahtungsfelder aufsetzbare Trägerplatte eine Vielzahl von mit Elektroden versehenen Gasentladungskanälen eingebracht, wobei die im Rahmen der Verdrahtungsfelder angeordneten Gasentladungskanäle zu den Meßstellen hin offen sind. Sind nun zwei ausgewählte Meßstellen beispielsweise durch eine Leiterbahn elektrisch leitend miteinander verbunden, so bilden die zugeordneten Gasentladungskanäle zwei in Reihe geschaltete Gasentladungsstrecken, die durch Anlegen einer hinreichend hohen Spannung an die Elektroden gezündet werden können. Mit der Zündung der Gesentladungen erfolgt dann ein Stromtransport, der zu Prüfzwecken ausgewertet werden kann. Unterbleibt die Zündung der Gasentladungen oder fließt nach einer Zündung ein zu geringer Strom, so kann auf eine unterbrochene oder von vorneherein nicht existierende elektrisch leitende Verbindung zwischen den ausgewählten Meßstellen geschlossen werden. Wird der an die Elektroden angelegten Spannung eine Wechselspannung überlagert, so kann die daraus resultierende Stromänderung phasenempfindlich zur angelegten Wechselspannung gemessen und für die Bestimmung des Widerstandes einer zwischen den ausgewählten Meßstellen bestehenden Verbindung herangezogen werden. Die bekannte Vorrichtung ermöglicht also Leitfähigkeits- und Isolationsmessungen, wobei durch das Vermeiden von ohm'schen Kontakten eine sehr hohe Zuverlässigkeit erreicht wird. Durch das Prinzip der ionischen Kontaktierung der Meßstellen über in äußerst geringen Abmessungen realisierbare Gasentladungskanäle können dann insbesondere auch Verdrahtungsfelder mit kleinen Rastermaßen der Meßstellen bis herab zu 0,1 mm zuverlässig geprüft werden. Bei einer hohen Anzahl der Meßstellen eines zu prüfenden Verdrahtungsfeldes treten jedoch nach wie vor Probleme auf, die durch die zahlreichen Zuleitungen und Schaltelemente für den Anschluß der Elektroden der Gasentladungskanäle zurückzuführen sind.

Der Erfindung liegt die Aufgabe zugrunde, bei einer Vorrichtung der eingangs genannten Art die Anzahl der Zuleitungen drastisch zu reduzieren.

Diese Aufgabe wird erfindungsgemäß durch die kennzeichnenden Merkmale des Anspruchs 1 gelöst.

Der Erfindung liegt die Erkenntnis zugrunde, daß der Anschluß der Elektroden von mehreren Gasentladungskanälen unter der Voraussetzung über gemeinsame Elektroden-Sammelleitungen vorgenommen werden kann, daß für die Einleitung einer Gasentladung in den den ausgewählten Meßstellen zugeordneten Gasentladungskanälen als zusätzliche Bedingung deren Beaufschlagung mit einer entsprechenden Strahlung erforderlich ist. Bei der elektrischen Funktionsprüfung von Verdrahtungsfeldern müssen also für die Zündung von Gasentladungen folgende Voraussetzungen vorliegen:

a. Zwischen den ausgewählten Meßstellen des Verdrahtungsfeldes muß eine elektrisch hinreichend leitende Verbindung vorhanden sein.

b. An die Elektroden der den ausgewählten Meßstellen zugeordneten Gasentladungskanäle ist über die entsprechenden Elektroden-Sammelleitungen eine Spannung angelegt, die in ihrem zeitlichen Verlauf und in ihrer Größe für sich alleine gesehen noch keine Gasentladung auslöst.

c. Die den ausgewählten Meßstellen zugeordneten Gesentladungskanäle sind gezielt mit einer Strahlung beaufschlagt, durch welche die Zündspannung bis zur Zündung einer Gasentladung erniedrigt wird oder durch welche die Zündverzögerung derart verkürzt wird, daß durch ein kurzzeitiges Anliegen der Zündspannung eine Zündung eintritt.

Bei der Voraussetzung a handelt es sich um eine Eigenschaft des jeweils zu prüfenden Verdrahtungsfeldes, während die Voraussetzungen b und c für eine eindeutige Adressierung der jeweils ausgewählten Meßstellen eines Verdrahtungsfeldes maßgeblich sind. Beim Zünden von Gasentladungen in Verbindung mit einer entsprechenden Stromstärke kann also auf das Vorhandensein einer elektrisch hinreichend leitenden Verbindung zwischen den adressierten Meßstellen geschlossen werden, während beim Nichtzünden eine derartige Verbindung fehlt oder unterbrochen ist.

Mit der erfindungsgemäßen Adressierung der ausgewählten Meßstellen bzw. der den ausgewählten Meßstellen zugeordneten Gasentladungskanäle kann die Anzahl der Zuleitungen erheblich reduziert werden, zumal den Elektroden-Sammelleitungen auch eine größere Anzahl von Gasentladungskanälen zugeordnet werden kann. Neben einer erheblichen Verringerung des Verdrahtungsaufwandes wird insbesondere die technische Machbarkeit von Vorrichtungen für die elektrische Funktionsprüfung von Leiterplatten mit großen Leiterplattenformaten und kleinen Rastermaßen wesentlich erleichtert und somit auch eine entscheidende Senkung der Herstellkosten bewirkt. Der zusätzliche Aufwand für die adressierbare Beaufschlagung der Gasentladungskanäle mit einer Gasentladungen einleitenden Strahlung ist gegenüber der genannten vorteilen als gering einzustufen.

Bei der erfindungsgemäßen Vorrichtung für die elektrische Funktionsprüfung von Verdrahtungsfeldern werden die Meßstellen ionisch kontaktiert, d.h. die zweite Elektrode der Gasentladungsstrecken wird unmittelbar durch die Meßstellen auf der Leiterplatte gebildet. Durch das Vermeiden von ohm'schen Kontakten wird dabei eine sehr hohe Zuverlässigkeit erreicht. Die Vorteile der erfindungsgemäßen Adressierung von Meßstellen bzw. Gasentladungskanälen mit einer erheblichen Reduzierung des Verdrahtungsaufwands ergeben sich jedoch auch dann, wenn eine ohm'sche Kontaktierung der Meßstellen durch am unteren Ende der Gasentladungskanäle angeordnete federnde Prüfspitzen vorgenommen wird. Diese federnden Prüfspitzen bilden dann die zweite Elektrode der Gasentladungsstrecken, d.h. sie werden an dem der Spitze gegenüberliegenden Ende ionisch kontaktiert und können mit geringeren Durchmessern realisiert werden als die mit einer Verdrahtung verbundenen herkömmlichen Prüfspitzen. Die geringen Rasterabmessungen bei einer ionischen Kontaktierung mit zu den Meßstellen hin offenen Gasentladungskanälen können mit Prüfspitzen jedoch nicht erreicht werden.

Gemäß einer bevorzugten Ausgestaltung der Erfindung sind die Elektroden der Gasentladungskanäle reihenweise miteinander verbunden. Eine derartige reihenweise Zusammenfassung der Elektrodenanschlüsse ist insbesondere auf eine regelmäßige Rasteranordnung der Meßstellen abgestimmt, wie als beispielsweise bei Leiterplatten in der Regel vorhanden ist. Es ergibt sich dann eine übersichtliche und besonders einfache Verlegung der Elektroden-Sammelleitungen.

Weiterhin ist es besonders vorteilhaft, wenn die Elektroden-Sammelleitungen quer zu den Hauptrichtungen der Verdrahtung der zu prüfenden Verdrahtungsfelder verlaufen. Durch diese Maßnahmen wird dem Umstand Rechnung getragen, daß zwei ausgewählten Meßstellen nicht die gleiche Elektroden-Sammelleitung zugeordnet sein darf. Verlaufen die Elektroden-Sammelleitungen beispielsweise unter einem Winkel von 45° zu den Hauptrichtungen der Verdrahtung, so können durch eine Verdrehung der gesamten Trägerplatte um einen Winkel von 90° oder 270° relativ zur Verdrahtung sämtliche Meßstellen sicher erfaßt werden.

Eine weitere Vereinfachung bei der Herstellung der Vorrichtung ergibt sich, wenn die Elektroden durch die Gasentladungskanäle überquerende Abschnitte der Elektroden-Sammelleitungen gebildet sind. In diesem Fall können dann für die Herstellung der Elektroden und Elektroden-Sammelleitungen insbesondere diejenigen Techniken eingesetzt werden, die sich bei der Herstellung von gedruckten Leiterplatten oder Schichtschaltungen bewährt haben.

Die Beaufschlagung ausgewählter Gasentladungskanäle mit einer Gasentladungen einleitenden Strahlung kann über auf die Gasentladungskanäle ablenkbare Strahlen gesteuert werden. Auch in diesem Fall kann dann auf bewährte Techniken zurückgegriffen werden, wie sie beispielsweise bei der Beschriftung von Teilen mit ablenkbaren Laserstrahlen eingesetzt werden (Laser 79 Opto-Elektronics, Band 2 bis 6, Juli 1979, Seiten 235 bis 239).

Es ist aber auch möglich, die Beaufschlagung ausgewählter Gasentladungskanäle mit einer ionisierenden Strahlung über den Gasentladungskanälen zuordenbare strahlungsdurchlässige Bereiche einer Maske zu steuern. Wird die Maske dann durch eine Flüssigkristallzelle mit den Gasentladungskanälen zugeordneten transparenten Elektroden gebildet, so kann die Beaufschlagung der Gasentladungskanäle mit der Gasentladungen einleitenden Strahlung auf besonders einfache Weise durch eine entsprechende Ansteuerung der transparenten Elektroden vorgenommen werden. Um auch hier die Anschlüsse der transparenten Elektroden zu vereinfachen, sind die transparenten Elektroden vorzugsweise über zugeordnete Sammelleitungen ansteuerbar. Eine weitere Vereinfachung des Anschlusses und der Ansteuerung der transparenten Elektroden ergibt sich, wenn die transparenten Elektroden reihenweise über die Sammelleitungen miteinander verbunden sind. Verlaufen die Sammelleitungen dann quer zu den Elektroden-Sammelleitungen, so ergibt sich eine besonder einfache Matrixadressierung der den ausgewählten Meßstellen zugeordneten Gasentladungskanäle.

Ausführungsbeispiele der Erfindung sind in der Zeichnung dargestellt und werden im folgenden näher beschrieben.

Es zeigen

Figur 1 das Grundprinzip einer erfindungsgemäßen Vorrichtung für die elektrische Funktionsprüfung von Leiterplatten,

Figur 2 eine Variante des in Figur 1 gezeigten Grundprinzips,

Figur 3 die Ausgestaltung einer Trägerplatte mit Gasentladungskanälen, Elektroden und Elektroden-Sammelleitungen,

Figur 4 den Einsatz der in Figur 3 dargestellen Trägerplatte in Verbindung mit einer steuerbaren Beaufschlagung der Gasentladungskanäle mit ablenkbaren Laserstrahlen und

Figur 5 den Einsatz der in Figur 3 dargestellten Trägerplatte in Verbindung mit einer durch eine Maske steuerbaren Beaufschlagung der Gasentladungskanäle mit einer ionisierenden Strahlung.

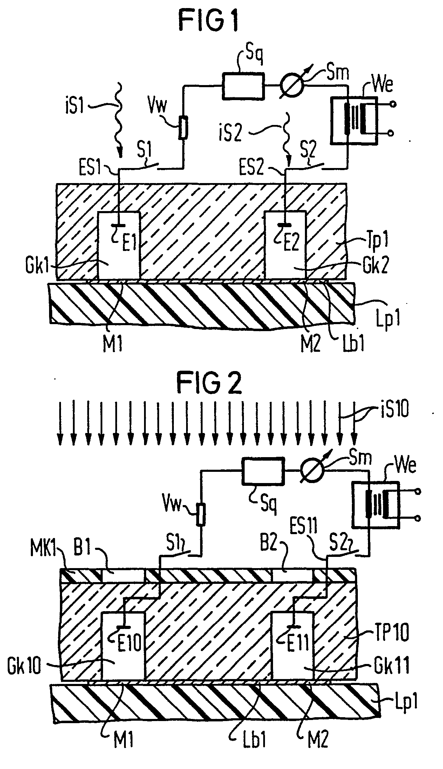

Figur 1 zeigt in stark vereinfachter schematischer Darstellung die prinzipielle Wirkungsweise einer Vorrichtung für die elektrische Funktionsprüfung von Leiterplatten auf der Basis einer berührungslösen ionischen Kontaktierung der Meßstellen über Gasentladungsstrecken. Es ist ein Teil einer mit Lp1 bezeichneten Leiterplatte zu erkennen, auf deren Oberseite die Enden einer Leiterbahn Lb1 Meßstellen M1 und M2 bilden. Auf die Oberseite der Leiterplatte Lp1 ist eine Trägerplatte Tp1 aus einem isolierenden Material wie z.B. Glas aufgesetzt, in welche in Form von Sacklöchern eine Vielzahl von Gasentladungskanälen eingebracht ist. In der Zeichnung sind dabei nur der der Meßstelle M1 zugeordnete Gasentladungskanal Gk1 und der Meßstelle M2 zugeordnete Gasentladungskanal Gk2 dargestellt. Auf der der Meßstelle M1 gegenüberliegenden Seite des Gasentladungskanals Gk1 ist eine Elektrode E1 angeordnet, welche an eine Elektroden-Sammelleitung ES1 angeschlossen ist. In entsprechender Weise ist eine Elektrode E2 des Gasentladungskanäls Gk2 an eine Elektroden-Sammelleitung ES2 angeschlossen. Über die Elektroden-Sammelleitung ES1 und ES2 sind dabei jeweils die Elektroden einer Vielzahl von in Figur 1 nicht dargestellten Gasentladungskanälen reihenweise miteinander verbunden.

Werden nun bei der elektrischen Funktionsprüfung der Leiterplatte Lp1 die beiden Meßstellen M1 und M2 ausgewählt, so werden die Elektroden E1 und E2 der zugeordneten Gasentladungskanäle Gk1 und Gk2 über die Elektroden-Sammelleitungen ES1 und ES2 angesteuert, wobei diese Ansteuerung durch Schalter S1 und S2 aufgezeigt ist. Zwischen den Schaltern S1 und S2 sind nacheinander in Reihe ein Vorwiderstand Vw, eine Spannungsquelle Sq, ein Strommeßgerät Sm und ein Wechselspannungserzeuger We angeordnet.

Die gesamte in Figur 1 dargestellte Anordnung befindet sich in einem evakuierbaren Raum unter einem verminderten Druck von beisielsweise $13,3 \cdot 10^{-3}$ bar (10 Torr), wobei der evakuierbare Raum mit einem Gas wie z.B. Stickstoff gefüllt ist. Somit sind zwischen der Elektrode E1 und der Meßstelle M1 sowie zwischen der Elektrode E2 und der Meßstelle M2 Gasentladungsstrecken gebildet, die über die Leiterbahn Lb1 in Reihe geschaltet sind. Die Spannung der Spannungsquelle Sq ist nun derart bemessen, daß an diese beiden in Reihe geschalteten Gasentladungsstrecken über die Schalter S1 und S2 die doppelte Brennspannung angelegt ist, deren Höhe jedoch keineswegs die doppelte Zündspannung erreichen darf. Eine Zündspannung der Gasentladungsstrecken wird erst eingeleitet, wenn die den ausgewählten Meßstellen M1 und M2 zugeordneten Gasentladungskanäle Gk1 und Gk2 zusätzlich mit einer ionisierenden Strahlung iS1 bzw. iS2 beaufschalgt werden. Diese ionisierende Strahlung iS1 bzw. iS2, bei welcher es sich um eine kurzwellige elektromagnetische Strahlung oder eine Korpuskularstrahlung handeln kann, setzt dabei die Zündspannung in den Gasentladungskanälen Gk1 und Gk2 so weit herab, daß die über die Schalter S1 und S2 angelegte Spannung für die Zündung der Gasentladungsstrecken ausreicht. Principiell ist eine Zündung von Gasentladungen also nur möglich, wenn die ausgewählten Gasentladungskanäle über ihre zugeordneten Elektroden-Sammelleitungen angesteuert und gleichzeitig gezielt mit einer Strahlung, insbesondere einer ionisierenden Strahlung beaufschalgt werden. Auf diese Weise ist dann auch eine sichere Adressierung der ausgewählten Gasentladungskanäle bzw. Meßstellen gewährleistet.

Zünden nun in den Gasentladungskanälen Gk1 und Gk2 Gasentladungen, so kann die Beaufschlagung der Gasentladungskanäle Gk1 und Gk2 mit der ionisierenden Strahlung iS1 bzw. iS2 beendet werden. Aus dem Brennen der beiden Gasentladungen, das über das in den Stromkreis eingeschaltete Strommeßgerät Sm registriert wird, kann geschlossen werden, daß die beiden Meßstellen M1 und M2 elektrisch hinreichend leitend miteinander verbunden sind bzw. daß die Leiterbahn Lb1 nicht unterbrochen ist. Für Messungen des Widerstandes zwischen den Meßstellen M1 und M2 wird über den Wechselspannungserzeuger We zusätzlich eine Wechselspannung überlagert, wobei diese Überlagerung wie im dargestellten Ausführungsbeispiel durch induktive Ankoppelung vorgenommen werden kann. Die Widerstandsmessungen werden am differentiellen Umkehrpunkt der Gasentladungscharakteristik vorgenommen, wobei die Innen-Widerstände der Gasentladungsstrecken praktisch Wechselstrommäßig überbrückt werden. Dabei führen kleine Schwankungen $\Delta U$ der überlagerten Wechselspannung zu relativ großen Schwankungen $\Delta I$ des Stromes. Das im Stromkreis angeordnete phasenempfindliche Strommeßgerät Sm, bei welchem es sich beispielsweise um einen handelsüblichen lock-in-amplifier handeln kann, registriert die Stromschwankungen $\Delta I$

und der Widerstand R kann aus der Beziehung $R=\Delta U/\Delta I$ ermittelt werden. Aus der Höhe des ermittelten Widerstandes R kann dann ggf. auf Fehler geschlossen werden, bei welchen die Leiterbahn Lb1 nur teilweise unterbrochen ist. Außerdem kann die Ermittlung des Widerstandes R auch für Isolationsmessungen herangezogen werden.

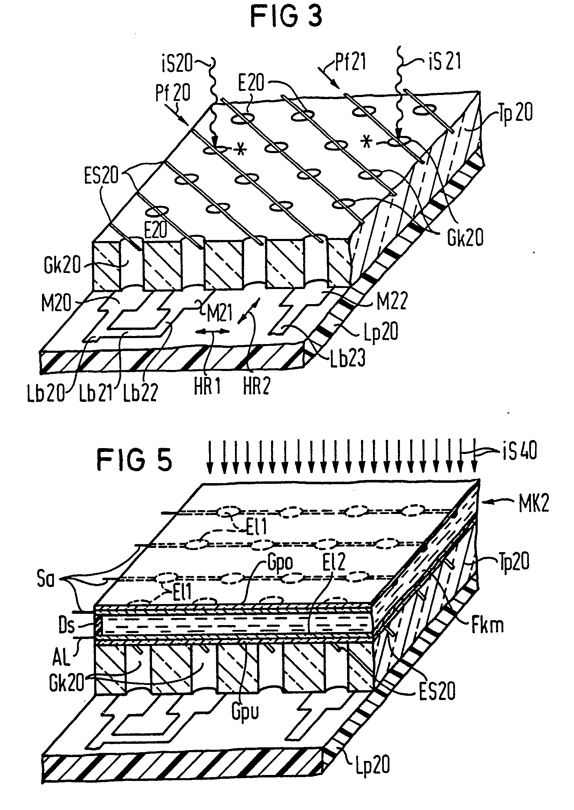

Figur 2 zeigt eine Variante, bei welcher die Trägerplatte mit Tp10 und die den Meßstellen M1 und M2 zugeordneten Gasentladungskanäle mit Gk10 und Gk11 bezeichnet sind. Die Ansteuerung der Elektroden E10 und E11 der Gasentladungskanäle Gk10 bzw. Gk11 erfolgt in der zuvor beschriebenen Weise über die Schalter S1 und S2 und entsprechende Elektroden-Sammelleitungen ES10 bzw. ES11. Die Beaufschalgung der ausgewählten Gasentladungskanäle Gk10 und Gk11 mit einer zunächst flächenförmig verteilten ionisierenden Strahlung iS10 wird hier jedoch mit Hilfe einer auf die Trägerplatte Tp10 aufgesetzten Maske Mk1 gesteuert. Diese Maske Mk1 läßt die ionisierende Strahlung iS10 nur in Bereichen B1 und B2 durch, die den ausgewählten Gasentladungskanälen Gk10 und Gk11 bzw. den ausgewählten Meßstellen M1 und M2 zugeordnet sind. Es ist ersichtlich, daß die gezielte Beaufschlagung ausgewählter Gasentladungskanäle über die jeweilige Lage von strahlungsdurchlässigen Bereichen einer Maske oder mehrerer Masken gesteuert werden kann.

Figur 3 zeigt in perspektivischer Darstellung einen Teil einer Leiterplatte Lp20, auf deren Oberfläche in Rastermaß angeordnete Meßstellen M20, M21 und M22 sowie Leiterbahnen Lb20, Lb21, Lb22 und Lb23 zu erkennen sind. Die zueinander senkrechten Hauptrichtungen der Leiterbahnen sind mit HR1 und HR2 bezeichnet. Auf die Oberseite der Leiterplatte Lp20 ist eine Trägerplatte Tp20 aufgesetzt, in welche eine Veilzahl zylindrischer Gasentladungskanäle Gk20 eingebracht ist. Die Trägerplatte Tp20 besteht aus fotolithographisch strukturierbarem Formglas, in welches die Gasentladungskanäle Gk20 mittels üblicher Maskierungs- und Ätztechniken eingebracht werden. In die Oberfläche der Trägerplatte Tp20 sind ferner geradlinige Rillen eingebracht, in welchen Elektroden-Sammelleitungen ES20 verlaufen. Die mit E20 bezeichneten Elektroden der Gasentladungskanäle Gk20 sind unmittelbar durch die Gasentladungskanäle Gk20 überquerende Abschnitte der Elektroden-Sammelleitungen ES20 gebildet. Die Herstellung der Elektroden-Sammelleitungen ES20 mit den zugehörigen Elektroden E20 kann mit auf dem Gebiet der gedruckten Schaltungen oder Schichtschaltungen üblichen Techniken vorgenommen werden, wobei als Materialien Edelmetalle wie z.B. Gold geeignet sind.

Die Lage der Gasentladungskanäle Gk20 entspricht genau dem Raster der Meßstellen einer zu prüfenden Leiterplatte Lp20, wobei in Figur 3 die genaue Zuordnung von in der Schnittebene der Trägerplatte Tp20 liegenden Gasentladungskanälen Gk20 zu den unmittelbar darunter liegenden Meßstellen M20, M21 und M22 deutlich zu erkennen ist. Es ist ferner zu erkennen, daß die Anzahl der in Zeilen und Spalten angeordneten Gasentladungskanäle Gk20 durchaus größer sein kann als die Anzahl der auf der Leiterplatte Lp20 vorhandenen Meßstellen.

Die Elektroden-Sammelleitungen ES20 verlaufen unter einem Winkel von 45° quer zu den Hauptrichtungen HR1 und HR2 der Leiterbahnen der Leiterplatte Lp20, wobei die Gründe für eine derartige Richtungswahl aus der nachfolgenden Erläuterung der Adressierung ausgewählter Meßstellen hervorgehen.

Werden bei der elektrischen Funktionsprüfung der Leiterplatte Lp20 zwei Meßstellen ausgewählt, so müssen die diesen Meßstellen zugeordneten Gasentladungskanäle durch eine entsprechende Adressierung exakt erfaßt werden. So werden beispielsweise die beiden mit einem Stern gekennzeichneten Gasentladungskanäle Gk20 über die zugeordneten Elektroden-Sammelleitungen ES20 elektrisch angesteuert, was durch Pfeile Pf20 und Pf21 angedeutet ist. Zur exakten Unterscheidung von den anderen diesen Elektroden-Sammelleitungen zugeordneten Gasentladungskanälen Gk20 werden die beiden ausgewählten und mit einem Stern gekennzeichneten Gasentladungskanäle Gk20 zusätzlich und gezielt mit einer ionisierenden Strahlung iS20 bzw. iS21 beaufschlagt. Erst mit dieser Beaufschlagung mit der ionisierenden Strahlung iS20 und iS21 werden die Voraussetzungen für die Zündung von Gasentladungen geschaffen. Zünden die Gasentladungen tatsächlich, so kann hieraus auf das Vorhandensein einer elektrisch leitenden Verbindung zwischen den ausgewählten Meßstellen geschlossen werden. Leitfähigkeits- und Isolationsmessungen können auf die im Zusammenhang mit Figur 1 beschriebene Weise vorgenommen werden.

Die vorstehend beschriebene Adressierung versagt nur dann, wenn den ausgewählten Meßstellen bzw. Gasentladungskanälen Gk20 die gleiche Elektroden-Sammelleitung ES20 zugeordnet ist. Derartige Meßstellen können dann dadurch erfaßt werden, daß eine zweite Trägerplatte mit einem anderen Verlauf der Elektroden-Sammelleitungen zusätzlich verwendet wird oder daß die vorhandene Trägerplatte Tp20 in einem zweiten Schritt in einer um einen winkel von 90° oder 270° verdrehten Anordnung eingesetzt wird.

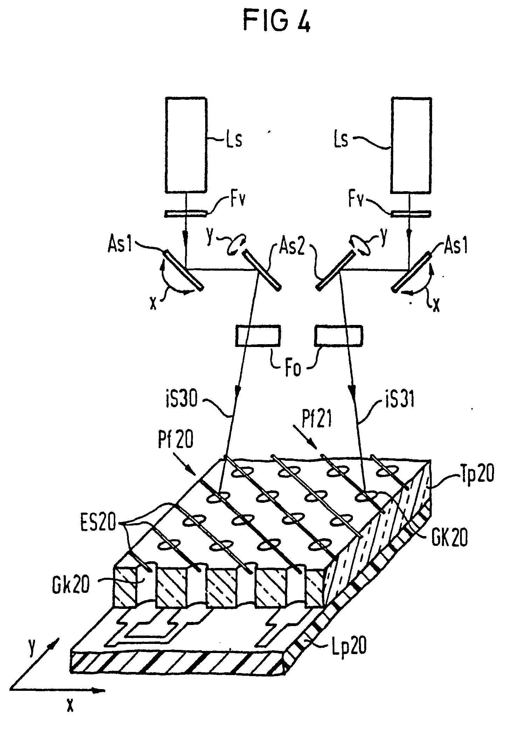

Figur 4 zeigt eine erste Möglichkeit, wie bei der in Figur 3 dargestellten Anordnung die steuerbare Beaufschlagung der Gasentladungskanäle mit einer ionisierenden Strahlung realisiert werden kann. Die Beaufschlagung der ausgewählten Gasentladungskanäle Gk20 mit einer hier mit iS30 und iS31 bezeichneten ionisierenden Strahlung wird mit Hilfe von ablenkbaren Laserstrahlen vorgenommen, wobei die Richtungen der Ablenkung durch ein ebenes x, y-Koordinatensystem aufgezeigt sind. Es sind zwei UV-Laser Ls vorhanden, in deren Strahlengang jeweils nacheinander ein Fotoverschluß Fv, ein erster Ablenkspiegel As1 für die Ablenkung in x-Richtung, ein zweiter Ablenkspiegel As2 für die Ablenkung in y-Richtung und eine Fokusoptik Fo angeordnet sind. Es ist zu erkennen, daß die ionisierenden Strahlung iS30 bzw. iS31 in Form fokussierter Laserstrahlen durch entsprechende Auslenkung der Ablenkspiegel As1 und As2 jeweils von oben her in die beiden ausgewählten Gasentladungskanäle Gk20 gelenkt werden kann. Die Trägerplatte Tp20 kann dabei auch mit einer in Figur 4 nicht dargestellten Abdeckplatte abgedeckt werden, die für die ionisierende Strahlung iS30 bzw. iS31 durchlässig sein muß und beispielsweise aus Glas besteht. Ferner kann die Ablenkung der ionisierenden Strahlung iS30 bzw. iS31 auf einfache Weise entsprechend dem jeweiligen Prüfprogramm über Rechner oder Mikrocomputer gesteuert werden.

Figur 5 zeigt eine zweite Möglichkeit, wie bei der in Figur 3 dargestellten Anordnung die steuerbare Beaufschlagung der Gasentladungskanäle mit einer ionisierenden Strahlung realisiert werden kann. Die Beaufschlagung der ausgewählten Gasentladungskanäle Gk20 mit einer hier mit iS40 bezeichneten flächenhaften ionisierenden Strahlung, beispielsweise einer über einen Parabolspiegel parallel-gerichteten UV-Strahlung, wird mit Hilfe einer steuerbaren Maske Mk2 vorgenommen. Die auf die Oberseite der Trägerplatte Tp20 aufgesetzte Maske Mk2 ist durch eine Flüssigkristallzelle gebildet, welche nach Art einer Flüssigkristallanzeige aufgebaut ist. Die dünne Zelle besteht aus zwei planparallelen Glasplatten Gpo und Gpu, die durch Distanzstücke Ds im Abstand zueinander gehalten sind und zwischen welchen sich eine Flüssigkristallmischung Fkm befindet. Die Unterseite der oberen Glasplatte Gpo ist mit einem lichtdurchlässigen Raster bedampft, wobei durch dieses Raster den Gasentladungskanälen Gk20 zugeordnete transparente Elektroden E11 und diese Elektroden E11 reihenweise miteinander verbindende Sammelleitungen Sa gebildet sind. Die Unterseite der unteren Glasplatte Gpu ist mit einer Elektrode E12 ganzflächig bedampft, wobei dieser transparenten Elektrode E2 eine äußere Anschlußleitung A1 zugeordnet ist. Beim Anlegen einer Spannung an eine Sammelleitung Sa und die Anschlußleitung A1 ändert sich im damit verbundenen elektrischen Feld die Transparenz der Flüssigkristallmischung Fkm, d.h. sie trübt ein und wird im Bereich unterhalb der transparenten Elektroden E11 der der Sammelleitung Sa zugeordneten horizontalen Zeile für die ionisierende Strahlung iS40 undurchlässig.

Auf die vorstehend beschriebene Weise können nun sämtliche Sammelleitungen Sa derart angesteuert werden, daß keine ionisierende Strahlung iS40 in die Gasentladungskanäle Gk20 gelangt. Wird nun der Anschluß einer Sammelleitung Sa gezielt abgeschaltet, so wird die zugeordnete horizontale Zeile von Gasentladungskanälen Gk20 mit der ionisierenden Strahlung iS40 beaufschlagt. Das die Sammelleitung Sa und die Elektroden-Sammelleitungen ES20 quer zueinander unter einem Winkel von 45° verlaufen wird eine Matrixadressierung der ausgewählten Meßstellen bzw. Gasentladungskanäle Gk20 ermöglicht.

Liegen zwei ausgewählte Meßstellen bzw. Gasentladungskanäle Gk20 in der gleichen horizontalen Zeile, so wird nur eine einzige Sammelleitung Sa abgeschaltet, während in allen anderen Fällen mit zwei Meßstellen jeweils zwei zugeordnete Sammelleitungen Sa abgeschaltet werden.

Bei den anhand der Figuren 3 bis 5 beschriebenen Ausführungsbeispielen beträgt das Rastermaß der Meßstellen und damit auch der Gasentladungskanäle Gk20 bespielsweise 1/40", d.h. etwa 0,6 mm. Der Durchmesser der Gasentladungskanäle Gk20 beträgt dann 0,3 mm und der etwa der Stärke der Trägerplatte Tp20 entsprechende Abstand d zwischen den Elektroden E20 und den zugeordneten Meßstellen 0,5 mm. Die gesamte Anordnung befindet sich bei einem reduzierten Druck p von etwa $13,3 \cdot 10^{-3}$ bar (10 Torr) in einer Stickstoffatmosphäre. Bei dem Produkt $p \cdot d = 6,5 \cdot 10^{-3}$ bar. mm (5 Torr · mm) liegt bei Stickstoff das Minimum der normalen Zündspannung, das etwa 350 Volt beträgt. An die Elektroden-Sammelleitungen wird dann eine Spannung von 650 Volt angelegt, so daß die Zündung der Gasentladungen erst durch die Herabsetzung der doppelten Zündspannung durch eine ionisierende Strahlung ausgelöst werden kann. Prinzipiell muß die angelegte Spannung zwischen der doppelten Brennspannung und dem doppelten Wert der normalen Zündspannung liegen.

## Patentansprüche

1. Vorrichtung für die elektrische Funktionsprüfung von Verdrahtungsfeldern, insbesondere von Leiterplatten (Lp1; Lp20), mit einer auf die Verdrahtungsfelder aufsetzbaren Trägerplatte (Tp1; Tp10; Tp20), in welche eine Vielzahl von mit Elektroden (E1, E2; E10, E11; E20) versehenen Gasentladungskanälen (Gk1; Gk2; Gk10, Gk11; Gk20) eingebracht ist, wobei jeweils mindestens zwei ausgewählte Meßstellen (M1, M2; M20, M21, M22) eines Verdrahtungsfeldes über die zugeordneten Gasentladungskanäle (Gk1, Gk2; Gk10, Gk11; Gk20) und deren Elektroden (E1, E2; E10, E11, E20) ionisch kontaktierbar sind, dadurch gekennzeichnet, daß jeweils die Elektroden (E1, E2; E10, E11; E20) mehrerer Gasentladungskanäle (Gk1, Gk2; Gk10, Gk11; Gk20) über eine zugeordnete Elektroden-Sammelleitung (ES1, ES2; ES10, ES11; ES20) miteinander verbunden sind und daß jeder Gasentladungskanal (Gk1, Gk2; Gk10, Gk11; Gk20) durch die seiner Elektrode (E1, E2; E10, E11; E20) zugeordnete Elektroden-Sammelleitung (ES1, ES2; ES10, ES11; ES20) und durch die steuerbare Beaufschlagung mit einer seine Gasentladung einleitenden Strahlung (iS1, iS2; iS10; iS20, iS21; iS30, iS31, iS40) auswählbar ist.

2. Vorrichtung nach Anspruch 1, dadurch gekennzeichnet, daß die Elektroden (E20) der Gasentladungskanäle (Gk20) reihenweise über die Elektroden-Sammelleitungen (ES20) miteinander verbunden sind.

3. Vorrichtung nach Anspruch 2, dadurch gekennzeichnet, daß die Elektroden-Sammelleitungen (ES20) quer zu den Hauptrichtungen (HR1, HR2) der Verdrahtung der zu prüfenden Verdrahtungsfelder verlaufen.

4. Vorrichtung nach einem der vorhergehenden Ansprüche, dadurch gekennzeichnet, daß die Elektroden (E20) durch die Gasentladungskanäle (Gk20) überquerende Abschnitte der Elektroden-Sammelleitungen (ES20) gebildet sind.

5. Vorrichtung nach einem der vorhergehenden Ansprüche, dadurch gekennzeichnet, daß die Beaufschlagung ausgewählter Gasentladungskanäle (Gk1, Gk2; Gk20) mit einer Gasentladungen einleitenden Strahlung (iS1, iS2; iS20, iS21; iS30, iS31) über auf die Gasentladungskanäle (Gk1, Gk2; Gk20) ablenkbare Strahlen steuerbar ist.

6. Vorrichtung nach einem der Ansprüche 1 bis 5, dadurch gekennzeichnet, daß die Beaufschlagung ausgewählter Gasentladungskanäle (Gk10, Gk11; Gk20) mit einer Gasentladungen einleitenden Strahlung (iS10; iS40) über den Gasentladungskanälen (Gk10, Gk11; Gk20) zuordenbare strahlungsdurchlässige Bereiche (B1, B2) einer Maske (Mk1; Mk2) steuerbar ist.

7. Vorrichtung nach Anspruch 6, dadurch gekennzeichnet, daß die Maske (M2) durch eine Flüssigkristallzelle mit den Gasentladungskanälen (Gk20) zugeordneten transparenten Elektroden (E11) gebildet ist.

8. Vorrichtung nach Anspruch 7, dadurch gekennzeichnet, daß die transparenten Elektroden (E11) über zugeordnete Sammelleitungen (Sa) ansteuerbar sind.

9. Vorrichtung nach Anspruch 8, dadurch gekennzeichnet, daß die transparenten Elektroden reihenweise über die Sammelleitungen (Sa) miteinander verbunden sind.

10. Vorrichtung nach Anspruch 9, dadurch gekennzeichnet, daß die Sammelleitungen (Sa) quer zu den Elektroden-Sammelleitungen (ES20) verlaufen.

**Revendications**

1. Dispositif pour tester le fonctionnement électrique de panneaux de câblage, notamment de plaquettes à circuits imprimés (Lp1; Lp20), comportant une plaque de support (Tp1; Tp10; Tp20), qui peut être posée sur les panneaux de câblage et dans laquelle sont ménagés un grand nombre de canaux de décharge dans un gaz (Gk1, Gk2; Gk10, Gk11; Gk20), équipés d'électrodes (E1, E2; E10, E11; E20), une liaison par voie ionique pouvant être établie avec respectivement au moins deux points de mesure sélectionnés (M1, M2; M20, M21, M22), d'un panneau de câblage par l'intermédiaire des canaux associés de décharge dans un gaz (Gk1, Gk2; Gk10, Gk11; Gk20), de leurs électrodes (E1; E2; E10; E11; E20), caractérisé par le fait que respectivement les électrodes (E1, E2; E10, E11; E20) de plusieurs canaux de décharge dans un gaz (Gk1, Gk2; Gk10, Gk11; Gk20) sont reliées entre eux par l'intermédiaire d'un conducteur associé (ES1, ES2; ES10, ES11; ES20) de réunion des électrodes et que chaque canal de décharge dans un gaz (Gk1, Gk2; Gk10, Gk11; Gk20) peut être sélectionné au moyen du conducteur (ES1, ES2; ES10; ES11; ES20) de réunion des électrodes, associées à son électrode (E1, E2; E10, E11; E20) et peut être sélectionné au moyen de l'application commandable d'un rayonnement (iS1, iS2; iS10; iS20, iS21; iS30, iS31; iS40) déclenchant sa décharge dans le gaz.

2. Dispositif suivant la revendication 1, caractérisé par le fait que les électrodes (E20) des canaux de décharge dans un gaz (Gk20) sont reliés entre aux en série par l'intermédiaire des conducteurs (ES20) de liaison des électrodes.

3. Dispositif suivant la revendication 2, caractérisé par le fait que les conducteurs (ES20) de réunion des électrodes s'étend transversalement par rapport aux directions principales (HR1, HR2) du câblage du panneau de câblage devant être contrôlé.

4. Dispositif suivant l'une des revendications précédentes, caractérisé par le fait que les électrodes (E20) sont formées par des sections des conducteurs (ES20) de réunion des électrodes qui s'étendant transversalement par rapport aux canaux de décharge dans un gaz (Gk20).

5. Dispositif suivant l'une des revendications précédentes, caractérisé par le fait que le fait que l'application d'un rayonnement (iS1, iS2; iS20, iS21; iS30, iS31), déclenchant des décharges dans le gaz, à des canaux sélectionnés de décharge dans un gaz (Gk1, Gk2; Gk20), peut être commandée par l'intermédiaire de rayons pouvant être déplacés au-dessus des canaux de décharge dans un gaz (Gk1, Gk2; Gk20).

6. Dispositif suivant l'une des revendications 1 à 5, caractérisé par le fait que l'application d'un rayonnement (iS10; iS40) qui déclenche des décharges dans le gaz, à des canaux sélectionnés de décharge dans un gaz (Gk10, Gk11; Gk20), peut être commandée par l'intermédiaire de zones (B1, B2) d'un masque (Mk1; Mk2) qui laissent passer les rayonnements et qui peuvent être associés aux canaux de décharge d'un gaz (Gk10, Gk11; Gk20).

7. Dispositif suivant la revendication 6, caractérisé par le fait que le masque (M2) est formé par une cellule à cristal liquide comportant des électrodes transparentes (E11), qui sont associées aux canaux de décharge dans un gaz (Gk20).

8. Dispositif suivant la revendication 7, caractérisé par le fait que les électrodes transparentes (E11) peuvent être commandées par l'intermédiaire de conducteurs associés de réunion (Sa).

9. Dispositif suivant la revendication 8, caractérisé par le fait que les électrodes transparentes sont reliées entre elles en série par l'intermédiaire des conducteurs de réunion (Sa).

10. Dispositif suivant la revendication 9, caractérisé par le fait que les conducteurs de réunion (Sa) s'étendent transversalement par rapport au conducteur (ES20) de réunion des électrodes.

**Claims**

1. Device for testing the electrical functioning of wiring matrices, especially of printed-circuit boards (Lp1; Lp20), having a carrier plate (Tp1; Tp10; Tp20) which can be placed on the wiring matrices and which contains a plurality of gas discharge channels (Gk1, Gk2; Gk10, Gk11; Gk20) provided with electrodes (E1, E2; E10, E11; E20), ionic contact of in each case at least two selected measuring points (M1, M2; M20, M21, M22) of a wiring matrix being possible via the assigned gas discharge channels (Gk1, Gk2; Gk10, Gk11; Gk20) and their electrodes (E1, E2; E10, E11; E20), characterized in that in each case the electrodes (E1, E2; E10, E11; E20) of a plurality of gas discharge channels (Gk1, Gk2; Gk10, Gk11; Gk20) are connected to one another via an assigned electrode bus line (ES1, ES2; ES10, ES11; ES20), and in that each gas discharge channel (Gk1, Gk2; Gk10, Gk11; Gk20) can be selected by the electrode bus line (ES1, ES2; ES10, ES11; ES20) assigned to its electrode (E1, E2; E10, E11; E20) and by the controllable subjection to a radiation (iS1, iS2; iS10; iS20, iS21; iS30, iS31, iS40) initiating its gas discharge.

2. Device according to Claim 1, characterized in that the electrodes (E20) of the gas discharge channels (Gk20) are connected to one another in series via the electrode bus lines (ES20).

3. Device according to Claim 2, characterized in that the electrode bus lines (ES20) run transversely to the main directions (HR1, HR2) of the wiring of the wiring matrices to be tested.

4. Device according to one of the preceding claims, characterized in that the electrodes (E20) are formed by the sections of the electrode bus lines (ES20) crossing over the gas discharge channels (Gk20).

5. Device according to one of the preceding claims, characterized in that the subjection of selected gas discharge channels (Gk1, Gk2; Gk20) to a radiation (iS1, iS2; iS20, iS21; iS30, iS31) initiating gas discharges can be controlled by means of beams which can be deflected onto the gas discharge channels (Gk1, Gk2; Gk20).

6. Device according to one of Claims 1 to 5, characterized in that the subjection of selected gas discharge channels (Gk10, Gk11; Gk20) to a radiation (iS10; iS40) initiating gas discharges can be controlled by radiation-transmissive regions (B1, B2) of a mask (Mk1; Mk2) which can be assigned to the gas discharge channels (Gk10, Gk11; Gk20).

7. Device according to Claim 6, characterized in that the peak (M2) is formed by a liquid-crystal cell with transparent electrodes (E11) assigned to the gas discharge channels (Gk20).

8. Device according to Claim 7, characterized in that the transparent electrodes (E11) can be triggered via assigned bus lines (Sa).

9. Device according to Claim 8, characterized in that the transparent electrodes are connected to one another in series via the bus lines (Sa).

10. Device according to Claim 9, characterized in that the bus lines (Sa) run transversely to the electrode bus lines (ES20).

# FIG 1

# FIG 2

1

## FIG 3

iS20    Pf21    iS21

Pf20    E20

ES20    E20    Tp20

Gk20    Gk20

M20    M22

M21    Lp20

Lb20  Lb21  Lb22    HR1    HR2    Lb23

## FIG 5

iS40

MK2

El1

Gpo    El2    Tp20

Sa    El1    Fkm

Ds

AL    ES20

Gk20    Gpu    Lp20

# FIG 4